**Europäisches Patentamt**

**European Patent Office**

**Office européen des brevets**

(19)

(11) Veröffentlichungsnummer : **0 343 374 B1**

(12)

# EUROPÄISCHE PATENTSCHRIFT

(45) Veröffentlichungstag der Patentschrift :
09.10.91 Patentblatt 91/41

(51) Int. Cl.[5] : **H05K 3/22**

(21) Anmeldenummer : **89107047.6**

(22) Anmeldetag : **19.04.89**

(54) Verfahren zur Reparatur von Leiterbahnunterbrechungen mittels deckungsgleicher Formteile.

(30) Priorität : **26.05.88 DE 3817899**

(43) Veröffentlichungstag der Anmeldung :
**29.11.89 Patentblatt 89/48**

(45) Bekanntmachung des Hinweises auf die
Patenterteilung :
**09.10.91 Patentblatt 91/41**

(84) Benannte Vertragsstaaten :
**AT BE CH DE FR GB IT LI NL**

(56) Entgegenhaltungen :
**EP-A- 0 043 586**
**IBM TECHNCICAL DISCLOSURE BULLETIN,**
**Band 29, Nr. 6, November 1986, Seiten**
**2702-2703, New York, US; "Master target vi-**
**deo inspection station"**

(73) Patentinhaber : **Siemens Nixdorf**
**Informationssysteme AG**
**Otto-Hahn-Ring 6**
**W-8000 München 83 (DE)**

(72) Erfinder : **Dederer, Günther, Dipl.-Ing. (FH)**
**Wotanstrasse 12**
**W-8034 Germering (DE)**

(74) Vertreter : **Fuchs, Franz-Josef, Dr.-Ing. et al**
**Postfach 22 13 17**
**W-8000 München 22 (DE)**

## Beschreibung

Die Erfindung betrifft ein Verfahren zur Reparatur von Leiterbahnunterbrechungen mittels deckungsgleicher Formteile, wobei diese beiderseits der Leiterbahnunterbrechungen mittels Widerstandserwärmung mit der Leiterbahn verbunden werden. Dies bezieht sich speziell auf Leiterbahnen, deren Höhe beispielsweise 20 bis 30 µm und deren Breite ca. 50 bis 70 µm beträgt.

Ein Verfahren zur Reparatur von Leiterbahnunterbrechungen ist bereits aus der DE-OS 3025875, die der EP-A-0043586 entspricht, bekannt. Hierin wird ein dreiteiliges Elektrodensystem verwendet, das aus einer zentrischen mit einem Vakuumanschluß zum Ansaugen eines Formteiles ausgestatteten Innenelektrode besteht, und das mittels konzentrisch und halbkreisförmig angeordneter Außenelektroden insgesamt zum Aufnehmen eines Formteiles, zum Absetzen desselben und zum Verbinden dieses Formteiles mit der unterbrochenen Leiterbahn dient. Zur Verbindung mittels Widerstandserwärmung wird in der Regel eine Hartlötverbindung eingesetzt. In der DE-PS 2251997 werden werkstoffkundliche und schweißtechnische Daten bezüglich einer solchen Hartlotverbindung offenbart.

Bei der weiter fortschreitenden Miniaturisierung von Leiterbahnen, die mittlerweile mäanderförmig in trapezartigen Leiterbahnzügen verlaufen und Dimensionierungen mit beispielsweise weniger als 70 µm Breite besitzen, sind Reparaturen an entsprechenden Leiterplatten mit herkömmlichen Verfahren nicht durchführbar. Dies ist im wesentlichen auf die mit dem menschlichen Auge nicht mehr zu verwirklichende Kontrolle bei den beschriebenen Dimensionen zurückzuführen.

Der Erfindung liegt die Aufgabe zugrunde, ein Verfahren zur Reparatur von Leiterbahnunterbrechungen bereitzustellen, das die dazu benötigten Formteile deckungsgleich zum Bereich der Leiterbahnunterbrechung und symmetrisch zu dieser auswählt, aufnimmt und zur Verbindung mittels Widerstandserwärmung entsprechend auf die Leiterbahnunterbrechung absetzt.

Die Lösung dieser Aufgabe wird durch den kennzeichnenden Teil des Anspruches 1 wiedergegeben.

Der Erfindung liegt die Erkenntnis zugrunde, daß die zuverlässige Handhabung von Formteilen zur Reparatur von Leiterbahnunterbrechungen, bezogen auf deren Deckungsgleichheit und Ausrichtung bezüglich der Leiterbahn, nur durch die Erfassung mittels Fernsehkamera an den Stellen der Leiterbahnunterbrechung, der Auswahl eines Formteiles und des Ortes der Verbindung zwischen Formteil und Leiterbahn, verwirklicht werden kann. Die dadurch erhältlichen drei Schwarz/Weiß-Fernsehbilder werden auf jeweils einen Farb-Eingang eines Farbmonitors gelegt und können durch wahlweises Mischen eine sehr exakte Kontrolle der Deckungsgleichheit gewährleisten. Dies geschieht durch einen Farbumschlag, der den Moment der Deckungsgleichheit zweier Schwarz/Weiß-Bilder kennzeichnet, von denen jedes vorher eine eigene und vom anderen Bild verschiedene Farbe aufwies. Bei Deckungsgleichheit erscheint im überdeckenden Bereich eine dritte, neue Farbe.

Eine besonders vorteilhafte Ausgestaltung der Erfindung sieht den Einsatz eines dreiteiligen Elektrodenkopfes vor, der mittels einer zentralen drehbaren Saugelektrode das Formteil aufnimmt, durch Verdrehen relativ zur Leiterbahnunterbrechung ausrichtet und auf dieser positioniert. Durch den Einsatz eines solchen Elektrodenkopfes wird das Formteil von der Aufnahme, beispielsweise in einem Magazin, bis zum Absetzen auf die Leiterbahn nur von der Saugelektrode gehalten und es sind keinerlei Übergabevorgänge notwendig.

Die für verschiedene Leiterbahngeometrien notwendigen Formteile werden zweckmäßigerweise in einer Vorratseinrichtung zur Verfügung gehalten, um sie einem Stanzwerkzeug zuzuführen, wobei die Saugelektrode das ausgestanzte Formteil direkt aus dem Stanzwerkzeug entnimmt.

Die drei auf einen Farbmonitor geschalteten Ausgänge der drei Schwarz/Weiß-Fernsehkameras können in vorteilhafterweise so koordiniert werden, daß die erste Fernsehkamera ständig einen Eingang belegt und entweder die zweite oder die dritte Fernsehkamera alternierend einen zweiten gemeinsamen Eingang belegen. Dies hat den Vorteil, daß der dritte Farbeingang für eine weitere Fernsehkamera und zusätzliche Kontrollfunktionen zur Verfügung steht.

Da beim Ausstanzvorgang und beim Widerstandsverbindungsvorgang die Fernsehkameras ausgeschwenkt sind, ist es vorteilhaft, eine vierte Fernsehkamera einzusetzen, um während des Verbindungsvorganges das auf die Leiterbahnunterbrechung abgesenkte Formteil zu kontrollieren.

Eine zweite Lösung der genannten Aufgabe wird durch den kennzeichnenden Teil des Anspruchs 6 wiedergegeben. Diese auf dem gleichen Erfindungsprinzip beruhende zweite Lösung sieht den Austausch der ersten und der zweiten sowie der ersten und der dritten Fernsehkamera jeweils durch ein Vergleichsmikroskop vor, das entsprechend zwei Bilder vergleicht.

Im folgenden wird anhand von schematischen Figuren ein Ausführungsbeispiel beschrieben.

Figur 1    zeigt eine Vorrichtung zur Durchführung des Verfahrens zur Reparatur von Leiterbahnunterbrechungen.

Figur 2    zeigt

a) eine Leiterbahn 10 mit Unterbrechung

b) eine Leiterbahn 10 mit deckungsgleich und symmetrisch zur Leiterbahnunterbrechung positioniertem Formteil 11.

Figur 3    zeigt die Positionierung der Saugelektrode 5 und des Stanzwerkzeuges 13 in bezug auf einen Formteilnutzen 14 während des Ausstanzvorganges.

Figur 4    zeigt das dreiteilige Elektrodensystem mit der separat drehbaren Saugelektrode 5.

Figur 5    zeigt einen Farbmonitor mit Kontrollbild.

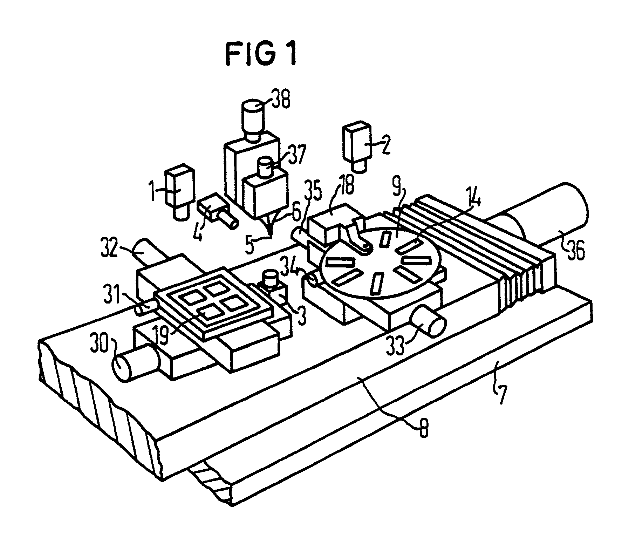

In der Figur 1 sind die Fernsehkameras 1 bis 4 dargestellt. Die erste Fernsehkamera 1 und die zweite Fernsehkamera 2 erfassen zum einen die Leiterplatte 19 mit einer Leiterbahnunterbrechung und zum anderen ein Magazin 9, in diesem Fall ein Rundmagazin, mit einem Stanzwerkzeug 18. Dies geschieht in beiden Fällen senkrecht von oben. Die Kamera 3 betrachtet senkrecht von unten den dreigeteilten Elektrodenkopf 6 mit der drehbaren Saugelektrode 5. Die Kamera 4 betrachtet schräg von der Seite den Ort, an dem die Verbindung durch Widerstandserwärmung zwischen Formteil 11 und Leiterbahn 10 durchgeführt wird. Dieser fällt mit der Position über der Fernsehkamera 3 zusammen. Die auf einem Stativ 7 gelagerte Vorrichtung besteht weiterhin aus einem Verschiebetisch 8, der mittels eines Schrittmotors 36 in einer Richtung, hin und her bewegbar ist. Die diesbezügliche Bewegung ist notwendig, um das Stanzwerkzeug 18 mit dem Magazin 9 und die Leiterplatte 19 von der jeweils dargestellten Position unter den dreiteiligen Elektrodenkopf 6 mit der drehbaren Saugelektrode 5 zu verfahren. Die Schrittmotoren 30 ; 31 ; 32 sorgen für eine Grob- und Feinjustierung der Leiterplatte 19 bezüglich eines auf dem Farbmonitor 16 festgelegten Nullpunktes. Gleiches gilt für das Magazin 9, wobei hier die Schrittmotoren 33 ; 34 eingesetzt werden. Der Schrittmotor 35 ist für die Bewegungen des Stanzwerkzeuges 18 zuständig. Die Schrittmotoren 38 ; 37 bewegen den Elektrodenkopf 6 und die separat drehbare Saugelektrode 5.

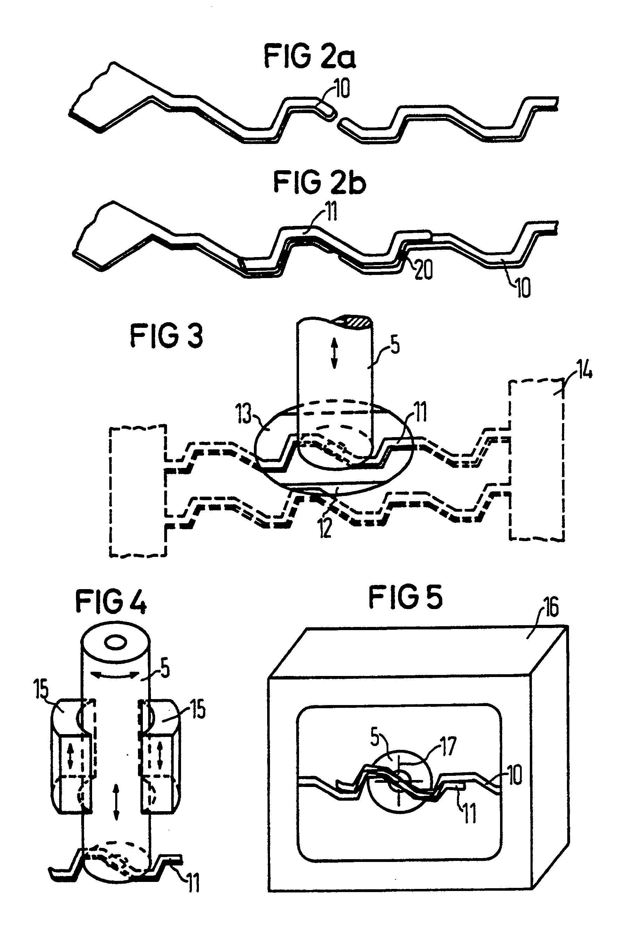

In der Figur 2a ist eine Leiterbahn 10 dargestellt, die einen Defekt in Form einer Unterbrechung aufweist. Die Figur 2b zeigt ein zur Umgebung der Leiterbahnunterbrechung deckungsgleiches und zu beiden Seiten annähernd gleichmäßig überbrückendes bzw. überlappendes Formteil 11, das auf die Leiterbahn positioniert wurde und durch zwei Verbindungszonen 20 mittels Hartlötung elektrisch und mechanisch mit der Leiterbahn 10 verbunden wurde.

In der Figur 3 ist beispielhaft wiedergegeben, wie aus einem Formteilnutzen 14, der mehrere Formteile 11 enthält, mittels der senkrecht absetzbaren und separat drehbaren Saugelektrode 5, dem Stanzstempel 13, von dem lediglich die Grundfläche dargestellt ist und der Schnittplattenöffnung 12 ein Formteil 11 ausgestanzt und mittels Vakuum angesaugt wird.

In der Figur 4 ist durch Doppelpfeile dargestellt, in welche Richtungen sich die Saugelektrode 5 und die Außenelektroden 15 bewegen lassen. Die Elektroden 5 ; 15 sind jede für sich in Kugelführungen verfahrbar und federnd abgestützt. Die Saugelektrode 5 ragt zentral aus dem Paar der Außenelektroden 15 nach unten heraus, da sie das Formteil 11 aus dem Stanzwerkzeug 18 zu einer Zeit entnehmen muß, in der die Außenelektroden 15 keine Verwendung finden. Der Verbindungsvorgang zwischen Formteil 11 und Leiterbahn 10 geschieht durch Aufsetzen aller drei Elektroden, wobei annähernd symmetrisch zur Leiterbahnunterbrechung jeweils zwischen der Saugelektrode 5 und den Außenelektroden 15 eine Widerstandsschweiß- oder Hartlötverbindung hergestellt wird.

In der Figur 5 ist angedeutet, wie mittels eines Farbmonitors 16 eine Leiterbahn 10, deren Leiterbahnunterbrechung etwa im Fadenkreuz 17 liegt, mittels eines Formteils 11 repariert wird. Das Fadenkreuz 17 stellt für die jeweils mit einer Kamera aufgenommene Position den Bezugspunkt dar. Anhand dieses Bezugspunktes läßt sich die Leiterbahnunterbrechung zentral auf dem Farbmonitor 16 erfassen, ebenso wie das Formteil 11, das symmetrisch, d.h. beiderseits gleichmäßig überlappend zur Leiterbahnunterbrechung positioniert wird. Der einzige Zeitpunkt, der nicht mittels einer der Kameras 1 ; 2 ; 3 erfaßbar ist, nämlich der Verbindungsvorgang mittels Widerstandserwärmung, kann von der Kamera 4 schräg von der Seite beobachtet werden.

Das erfindungsgemäße Verfahren beinhaltet speziell in diesem Ausführungsbeispiel noch weitere wesentliche Vorteile :

— Die verwendeten Formteile 11 können aus folgenden Materialien hergestellt sein :

Als Trägermaterial ist Kupfer, Nickel oder auch eine Legierung wie z.B. CuNi30 verwendbar. Die Plattierungsschicht wird vorzugsweise aus LAg72 hergestellt, wobei bessere Verbindungseigenschaften noch mittels des Hartlotes LAg15 P5 erzielt wurden.

— Das Stanzwerkzeug 18 ist als Fensterstanzwerkzeug ausgebildet und weist einen seitlich abgeflachten, runden Stanzstempel 13 auf. Dies ist deutlich in der Figur 3 anhand der abgebildeten Grundfläche des Stanzstempels 13 erkennbar. Hierdurch kann in einem Formteilnutzen 14 beim Ausstanzen eines Formteils 11 eine Beschädigung benachbarter Formteile 11 verhindert werden. Es ist ebenfalls raumsparend für kleineren Teilungsabstand im Formteilnutzen 14.

— Sämtliche ebenen x-y-Bewegungen werden durch Schrittmotore gesteuert. Dadurch sind aus einer Vielzahl von Formteilnutzen 14, die in Magazinen 9 enthalten sind, verschiedene Leiterbahnkonfigurationen entsprechend der Leiterbahnunterbrechung auswählbar.

— Ebenso ist die Anordnung von mehreren Fensterstanzwerkzeugen für die Aufnahme unterschiedlicher, vorgestanzter Formteilnutzen in verschiedenartigen Magazinen möglich, um unterschiedliche Leiterbahngeometrien abzudecken.

Sämtliche Schrittmotoren sind entsprechend der Dimensionierung der Leiterbahnen und der Reparaturformteile so ausgelegt, daß die Deckungsgleichheit beim Vergleich mehrerer Bilder genau eingestellt werden kann.

Die Ausrichtung der dritten Fernsehkamera 3 ist so gewählt, daß das von der Saugelektrode 5 gehaltene Formteil 11 deckungsgleich positioniert werden kann und, nachdem die Leiterplatte 19 unter die Saugelektrode gefahren wurde, entsprechend auf die Leiterbahn absenkbar ist.

Anstelle von Fernsehkameras sind teilweise auch Mikroskope einsetzbar. Hierbei ist es zweckmäßig, Vergleichsmikroskope (zwei Objektive, ein Okular) zu verwenden. Vergleichsmikroskope können zweckmäßigerweise anstelle der ersten und der zweiten Fernsehkamera 1 ; 2, sowie anstelle der ersten und der dritten Fernsehkamera 1 ; 3 eingesetzt werden. Anstelle der vierten Fernsehkamera 4 kann ein schräg angeordnetes Stereomikroskop direkt auf die Unterbrechung der Leiterbahn 10 gerichtet werden.

**Patentansprüche**

1. Verfahren zur Reparatur von Leiterbahnunterbrechungen mittels deckungsgleicher Formteile, wobei diese beiderseits der Leiterbahnunterbrechungen mittels Widerstandserwärmung mit der Leiterbahn verbunden werden, **dadurch gekennzeichnet, daß**
   a) 1. der Ort der Leiterbahnunterbrechung und dessen Umgebung,
   2. ein zur Leiterbahnunterbrechung deckungsgleiches Formteil und
   3. die Positionierung des Formteiles bezüglich der Leiterbahnunterbrechung mit
   jeweils mindestens einer Schwarz/Weiß-Fernsehkamera (1 ; 2 ; 3) erfaßt werden,
   b) die Deckungsgleichheit von Formteil und Leiterbahn an der Leiterbahnunterbrechung und deren Umgebung mittels Vergleich der Bilder der ersten und zweiten Fernsehkamera (1 ; 2) kontrolliert wird,
   c) die Positionierung nach a) 3. mittels Vergleich der Bilder der ersten und dritten Fernsehkamera (1 ; 3) geschieht,
   d) der Vergleich der Bilder der einzelnen Schwarz/Weiß-Fernsehkameras (1 ; 2 ; 3) auf einem Farbmonitor geschieht, auf dessen drei Farb-Eingänge jeweils eine Schwarz/Weiß-Fernsehkamera (1 ; 2 ; 3) im Wechsel zwischen erster mit zweiter Kamera (1 ; 2) oder erster mit dritter Kamera (1 ; 3) geschaltet ist,

2. Verfahren nach Anspruch 1, **dadurch gekennzeichnet,** daß ein dreigeteilter Elektrodenkopf (6) mit zentraler drehbarer Saugelektrode (5) das Formteil (11) mittig festhält und durch Verdrehen der Saugelektrode (5) und/oder Verfahren des dreigeteilten Elektrodenkopfes (6) relativ zur Leiterbahnunterbrechung positioniert.

3. Verfahren nach Anspruch 2, **dadurch gekennzeichnet,** daß verschiedenartige Formteile (11) für unterschiedliche Leiterbahngeometrie in mindestens einem Stanzwerkzeug (13) zur Aufnahme durch die Saugelektrode (5) zur Verfügung stehen.

4. Verfahren nach einem der vorhergehenden Ansprüche, **dadurch gekennzeichnet,** daß ein Farbeingang des Farbmonitors mit der ersten Fernsehkamera (1) und ein zweiter Farbeingang alternierend mit der zweiten oder dritten Fernsehkamera (2 ; 3) belegt ist.

5. Verfahren nach Anspruch 4, **dadurch gekennzeichnet,** daß eine vierte Fernsehkamera (4) zur Beobachtung des auf die Leiterbahnunterbrechung abgesenkten Formteiles und zur Kontrolle der Schweißverbindung eingesetzt wird.

6. Verfahren zur Reparatur von Leiterbahnunterbrechungen mittels deckungsgleicher Formteile, wobei diese beiderseits die Leiterbahnunterbrechungen mittels Widerstandserwärmung mit der Leiterbahn verbunden werden, **dadurch gekennzeichnet, daß**
   a) 1. der Ort der Leiterbahnunterbrechung und dessen Umgebung sowie ein zur Leiterbahnunterbrechung deckungsgleiches Formteil mit einem ersten Vergleichsmikroskop und
   2. der Ort der Leiterbahnunterbrechung und dessen Umgebung sowie die Positionierung des Formteils bezüglich der Leiterbahnunterbrechnung mit einem zweiten Vergleichsmikroskop erfaßt werden,
   b) die Deckungsgleichheit von Formteil und Leiterbahn an der Leiterbahnunterbrechung und deren Umgebung mit dem ersten Vergleichsmikroskop kontrolliert wird, und daß
   c) die Positionierung des Formteils bezüglich der Leiterbahnunterbrechung mit Hilfe des zweiten Vergleichsmikroskops geschieht.

# EP 0 343 374 B1

## Claims

1. Method for repairing conductor path interruptions by means of shaped conformal elements, these elements being joined to the conductor path on both sides of the conductor path, interruptions by means of resistance heating, characterised in that

a) 1. the location of the conductor path interruption and its environment,

2. a shaped element, conformal to the conductor path interruption, and

3. the positioning of the shaped element with respect to the interruption in the conductor path

are each determined using at least one black and white television camera (1 ; 2 ; 3),

b) the conformal nature of the shaped element and the conductor path at the conductor path interruption and their environment are checked by comparison of the images of the first and second television camera (1 ; 2),

c) the positioning according to a) 3. is carried out by comparison of the images of the first and third television camera (1 ; 3),

d) the comparison of the images from the individual black and white television cameras (1 ; 2 ; 3) is carried out on a colour monitor, to each of whose three colour inputs is connected one black and white camera (1 ; 2 ; 3) alternating between the first and second camera (1 ; 2) or the first and third camera (1 ; 3),

2. Method according to Claim 1, characterised in that a three-section electrode head (6) with a central rotating suction electrode (5) holds the shaped element (11) centrally and positions the latter relative to the conductor path interruption by rotating the suction electrode (5) and/or traversing the three-section electrode head (6),

3. Method according to Claim 2, characterised in that various types of shaped elements (11) for different conductor path geometries are made available in at least one stamping tool (13) to be picked up by the suction electrode (5).

4. Method according to one of the preceding claims, characterised in that one colour input of the colour monitor is connected to the first television camera (1) and a second colour input is connected alternately to the second or third television camera (2 ; 3).

5. Method according to Claim 4, characterised in that a fourth television camera (4) is used to observe the shaped element that is lowered onto the conductor path interruption and to check the welded joint.

6. Method for repairing conductor path interruptions by means of shaped conformal elements, these elements being connected to the conductor path on both sides of the conductor path interruptions by means of resistance heating, characterised in that

a) 1. the location of the conductor path interruption and its environment together with a shaped element that is conformal to the conductor path interruption is determined using a first comparison microscope and

2. the location of the conductor path interruption and its environment together with the positioning of the shaped element with respect to the conductor path interruption are determined using a second comparison microscope,

b) the conformal nature of the shaped element and the conductor path at the conductor path interruption and its environment is checked using the first comparison microscope, and in that

c) the positioning of the shaped element with respect to the conductor path interruption is carried out with the aid of the second comparison microscope.

## Revendications

1. Procédé pour réparer des interruptions d'une voie conductrice au moyen de pièces de forme de même configuration, que l'on raccorde à la voie conductrice, des deux côtés des interruptions de cette dernière, au moyen d'un chauffage par résistance, caractérisé par le fait que

a) 1. l'emplacement de l'interruption de la voie conductrice et son environnement,

2. une pièce de forme, dont la configuration coïncide avec l'interruption de la voie conductrice, et

3. le positionnement de la pièce de forme par rapport à l'interruption de la voie conductrice,

sont détectés à l'aide respectivement d'au moins une caméra de télévision en noir et blanc (1 ; 2 ; 3),

b) l'identité de forme entre la pièce de forme et la voie conductrice au niveau de l'interruption de cette dernière et de son environnement est contrôlée au moyen de la comparaison des images des première et seconde caméras de télévision (1 ; 2),

c) le positionnement selon a) 3. est réalisé au moyen d'une comparaison des images des première et troisième caméras de télévision (1 ; 3),

d) la comparaison des images des différentes caméras de télévision en noir et blanc (1 ; 2 ; 3) est réalisée sur un moniteur en couleurs, aux trois entrées des signaux couleurs duquel est raccordée respectivement une caméra de télévision en noir et blanc (1 ; 2 ; 3) avec alternance entre les première et seconde caméras (1 ; 2) ou entre les première et troisième cambras (1 ; 3).

2. Procédé suivant la revendication 1, caractérisé par le fait qu'une tête porte-électrodes (6) formée de trois éléments et comportant une électrode centrale rotative d'aspiration (5) maintient fermement en position centrée la pièce de forme (11) et la positionne par rapport à l'interruption de la voie conductrice par rotation de l'électrode d'aspiration (5) et/ou déplacement de la tête d'électrode (6) formée de trois éléments.

3. Procédé suivant la revendication 2, caractérisé par le fait qu'on dispose de pièces de forme (11) de différents types pour différentes géométries de la voie conductrice dans au moins un outil de poinçonnage (13) pour être reçues par l'électrode d'aspiration (5).

4. Procédé suivant l'une des revendications précédentes, caractérisé par le fait qu'une entrée du signal couleur du moniteur en couleurs est raccordée à la première caméra de télévision (1) et qu'une seconde entrée du signal couleur est raccordée en alternance à la seconde ou à la troisième caméra de télévision (2 ; 3).

5. Procédé suivant la revendication 3, caractérisé par le fait qu'on utilise une quatrième caméra de télévision (4) pour observer la pièce de forme abaissée sur l'interruption de la voie conductrice et pour contrôler la liaison soudée.

6. Procédé pour réparer des interruptions d'une voie conductrice à l'aide de pièces de forme de même configuration, que l'on raccorde à la voie conductrice des deux côtés des interruptions de cette dernière à l'aide d'un chauffage à résistance, caractérisé par le fait que

a) 1. l'emplacement de l'interruption dans la voie conductrice et son environnement ainsi qu'une pièce de forme dont la forme coïncide avec l'interruption de la voie conductrice sont détectés à l'aide d'un premier microscope comparateur, et

2. l'emplacement de l'interruption de la voie conductrice et son environnement ainsi que le positionnement de la pièce de forme par rapport à l'interruption de la voie conductrice sont détectés au moyen d'un second microscope comparateur,

b) l'identité de forme entre la pièce de forme et la voie conductrice au niveau de l'interruption de cette dernière et de son environnement est contrôlée au moyen du premier microscope comparateur, et que

c) le positionnement de la pièce de forme par rapport à l'interruption de la voie conductrice est réalisé à l'aide du second microscope comparateur.

# FIG 1

## FIG 2a

## FIG 2b

## FIG 3

## FIG 4

## FIG 5